(19) Europäisches Patentamt
European Patent Office
Office européen des brevets

(11) EP 1 560 785 B1

(12) **FASCICULE DE BREVET EUROPEEN**

(45) Date de publication et mention de la délivrance du brevet:
**04.04.2007 Bulletin 2007/14**

(21) Numéro de dépôt: **03786053.3**

(22) Date de dépôt: **12.11.2003**

(51) Int Cl.:
***B81B 1/00*** $^{(2006.01)}$ ***B01J 19/00*** $^{(2006.01)}$
***B81B 7/00*** $^{(2006.01)}$

(86) Numéro de dépôt international:
**PCT/FR2003/050117**

(87) Numéro de publication internationale:
**WO 2004/046020 (03.06.2004 Gazette 2004/23)**

(54) **MICRO-SYSTÈME A REMPLISSAGE DE MICRO-BILLES ET PROCÉDÉ D'OBTENTION**

MIKROBEHÄLTER FÜR MIKROKUGELN UND VERFAHREN ZU SEINER HERSTELLUNG

MICROBEAD-FILLED MICROSYSTEM AND PRODUCTION METHOD THEREOF

(84) Etats contractants désignés:
**AT BE BG CH CY CZ DE DK EE ES FI FR GB GR HU IE IT LI LU MC NL PT RO SE SI SK TR**

(30) Priorité: **13.11.2002 FR 0214177**

(43) Date de publication de la demande:
**10.08.2005 Bulletin 2005/32**

(73) Titulaire: **COMMISSARIAT A L'ENERGIE ATOMIQUE**
**75015 Paris (FR)**

(72) Inventeurs:
- **COMBETTE, Philippe**
  **F-34170 Castelnau Le Lez (FR)**
- **MITTLER, Frédérique**
  **F-38120 Saint-Egreve (FR)**
- **CAILLAT, Patrice**
  **38000 Grenoble (FR)**

(74) Mandataire: **Poulin, Gérard**
**Société BREVATOME**
**3, rue du Docteur Lancereaux**
**75008 Paris (FR)**

(56) Documents cités:
**WO-A-00/51720** **WO-A-01/06239**
**WO-A-99/09042** **US-A- 5 942 443**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 1 560 785 B1

## Description

### Domaine technique

La présente invention concerne un micro-système destiné à recevoir des billes de diamètre défini.

L'invention concerne également un procédé de fabrication ainsi qu'un procédé de remplissage d'un tel micro-système pour obtenir un micro-réacteur.

L'invention est enfin relative à un procédé pour réaliser une réaction biochimique ou biologique qui met en oeuvre ledit micro-système rempli de billes.

Le domaine de l'invention peut être défini comme celui des systèmes miniaturisés ou micro-systèmes qui sont utilisés essentiellement pour l'analyse chimique et la synthèse.

L'intégration de billes dans des micro-systèmes est largement utilisée dans le cadre de l'analyse ou des réactions biochimiques : l'utilisation de ces billes pré-fonctionnalisées, dont le diamètre va de la dizaine de nanomètres jusqu'à la centaine de micromètres, permet de disposer de fonctions chimiques sans passer par des étapes de fonctionnalisation des différentes composantes d'un micro-système.

Ces billes sont également utilisées dans les systèmes de séparation de type chromatographique pour lesquels elles sont empilées dans des capillaires de différents diamètres.

Plusieurs autres applications mettent en jeu l'utilisation de billes dans des micro-systèmes (dispositifs alors connus sous le terme de micro-réacteurs), notamment pour la pré-concentration de protéines, pour des réactions mettant en jeu des reconnaissances antigène-anticorps.... Leurs applications peuvent être également étendues au domaine de la chimie.

### Etat de la technique

Des exemples de micro-systèmes utilisant ces billes sont plus précisément décrits dans les documents suivants.

Dans le document **[1]** cité à la fin de la présente description, les auteurs présentent un micro-système dédié à une séparation du type chromatographique : deux barrières délimitent une cavité et permettent de capturer des billes présentant à leur surface une phase hydrophobe du type octadécylsilane. L'introduction des billes dans la cavité est réalisée par électro-osmose.

Une différence de dimension entre la profondeur de la cavité et la hauteur des barrières induit un blocage des billes dont le diamètre est supérieur à cette valeur. Dans ce dispositif, une fois les billes introduites dans la cavité, on peut théoriquement les en retirer en utilisant un flux inverse à celui utilisé pendant l'introduction, soit par électro-osmose, soit par une pompe classique. Toutefois, après utilisation, il s'avère que l'extraction des billes de la cavité est compliquée. Par ailleurs, bien que le remplissage soit homogène, les différentes images de la cavité en cours de remplissage laissent apparaître des zones présentant des hétérogénéités.

Dans le document **[2]** cité à la fin de la présente description, les auteurs utilisent un dispositif quasi identique pour réaliser une réaction enzymatique, suivi d'une analyse des produits issus de cette réaction. Cette fois, des billes d'un diamètre compris entre 40 et 60 micromètres sont introduites dans une cavité à l'aide d'une pompe classique. Ici, compte tenu des différents diamètres des billes, leur empilement au sein de la cavité implique des hétérogénéités.

Dans le document **[3]** cité à la fin de la présente description, les auteurs présentent un autre système permettant le blocage de micro-sphères. Une chambre de réaction est constituée de barreaux réalisés lors de la fabrication du dispositif et dont l'espacement est inférieur au diamètre des billes à bloquer. Une fois de plus, l'introduction des billes se fait une fois le système fermé. La solution apportée par cet ensemble de barrières ne permet pas, tout comme dans les dispositifs précédents, de garantir un remplissage exempt de toutes hétérogénéités. Ici, 1a disposition de la chambre emprisonnant les billes permet de mieux les en extraire à l'aide d'un flux de liquide contraire à celui employé pour le remplissage. Cependant, on peut craindre avec ce système que des amas globaux de billes viennent boucher les canaux et empêcher soit le remplissage, soit la vidange de la chambre. De plus, rien n'est prévu pour assurer un espacement constant entre les billes tout le long du micro-système.

Les auteurs du document **[4]**, cité à la fin de la présente description, présentent une méthode pour assembler, de façon locale, différents types de micro-billes. Le principe repose sur la génération d'une matrice de disques séparés les uns des autres par une surface hydrophobe. La surface de chacun de ces disques est ensuite chimiquement modifiée par dépôt type « micro-contact printing » qui utilise une matrice préalablement imbibée des produits à déposer. La puce munie de ces disques présentant des groupements réactionnels est ensuite trempée dans une solution contenant des micro-sphères en solution. Ces micro-sphères vont s'adsorber à la surface des disques avec une affinité propre à la nature des groupements réactionnels présents à la surface des micro-sphères et à la surface des disques. Mais ici, du fait même du mode de réalisation du dispositif, on ne peut obtenir qu'une seule couche de billes sur le micro-système.

Le document WO-A-9909042 divulgue un dispositif et un procédé permettant de séparer des éléments, tel que des acides nucléiques, des autres éléments contenus dans un fluide. Les billes utilisées dans le dispositif (figure 14)

sont entassées en vrac dans un espace (chambre 26) comprenant une barrière 52 disposé adjacente à l'orifice de sortie 30 pour empêcher les billes de sortir de la chambre 26. Les billes ne sont pas ordonnées et rangées de manières à former des empilements dans lesquels chaque bille est située l'une au-dessus de l'autre et où les billes d'un empilement ne sont pas en contact avec les billes d'un autre empilement.

Le document US-A-5942443 concerne des dispositifs et des procédés permettant de séparer et de trier un large nombre de composés différents présents dans un fluide échantillon. Le dispositif décrit dans ce document ne comprend pas de cavité munie d'éléments bloquants ayant la forme de colonnes. Par ailleurs, les billes ne sont pas empilées: seule une bille peut aller se loger dans les interstices comme on peut le voir sur la figure 4A. Les billes s'accumulent en vrac au dessus d'une membrane. Les billes ne sont pas empilées les unes aux dessus des autres de manière ordonnée de sorte que chaque bille soit en contact avec deux billes au maximum.

Les travaux précédemment cités mettent en évidence les intérêts de ces micro-billes, tant sur le point de la facilité d'utilisation que sur le vaste choix des fonctions biochimiques qu'elles peuvent apporter. Cependant, ces dispositifs présentent encore des inconvénients, notamment l'opération de remplissage des micro-systèmes à l'aide de billes fonctionnalisées qui demeure une opération délicate. Concernant ce point en particulier, il est important de noter que l'intégration des micro-billes dans les dispositifs précédemment cités ne se fait qu'après fermeture des réservoirs avec un capot. Ceci implique notamment la réalisation d'un système bloquant les billes à un endroit précis, mais également une gestion, d'une part, du fluide porteur des billes et d'autre part, du dispositif de pompage associé. Ces étapes pourraient être grandement simplifiées s'il était possible d'introduire les billes dans les réservoirs avant fermeture de ces derniers. Dans ce cas, le remplissage des réservoirs par les micro-billes serait beaucoup plus aisé puisque l'accessibilité serait grandement augmentée. Parallèlement à ce mode de remplissage, il faudrait définir une géométrie de réservoir telle qu'il puisse servir de micro-tamis et assurer un empilement régulier et une localisation précise des micro-billes. Une fois les micro-billes enchâssées dans le réservoir, la fermeture avec un capot permettrait d'assurer son étanchéité. Par ailleurs, si l'on veut insérer des billes de fonctions différentes, il serait intéressant de pouvoir placer ces billes à des endroits déterminés et ainsi contrôler les endroits où doivent avoir lieu les réactions chimiques.

Il ressort de ce qui précède qu'il existe un besoin pour un micro-système dont le remplissage avec des micro-billes serait aisé et permettrait également d'obtenir une localisation précise et reproductible desdites billes au sein du micro-système.

## Exposé de l'invention

Le but de la présente invention est de fournir un micro-système qui réponde, entre autres, à ces besoins.

Ce but et d'autres encore sont atteints, conformément à l'invention par un micro-système destiné à recevoir des billes et à obtenir une localisation précise desdites billes à des endroits déterminés dans le micro-système, caractérisé en ce qu'il comporte un réservoir présentant une cavité, ladite cavité munie d'éléments bloquants permettant d'ordonner et d'empiler les billes dans les interstices entre les éléments bloquants, les interstices constituant lesdits endroits déterminés, un capot fermant hermétiquement la cavité et des moyens d'entrée et des moyens de sortie permettant la circulation d'un fluide dans la cavité.

Avantageusement, les éléments bloquants dudit micro-système peuvent être constitués par des colonnes solidaires du fond de la cavité ou du capot. Le matériau des billes peut être choisi, selon l'application, parmi les matériaux minéraux, les métaux ou les composés organiques selon la fonction qu'elles doivent porter.

Si ledit micro-système est destiné à recevoir des billes ayant toutes le même diamètre, les éléments bloquants peuvent être régulièrement disposés selon un réseau bidimensionnel. Dans ce cas, le choix du réseau pour la disposition des éléments bloquants dans la cavité se fait en fonction du rapport volume de billes sur surface disponible que l'on veut obtenir dans le micro-système, ainsi que du diamètre des billes à y insérer. Les billes placées dans un même interstice ont le même diamètre.

Selon un premier mode de réalisation, le réseau bidimensionnel peut être une maille hexagonale.

Selon un deuxième mode de réalisation, le réseau bidimensionnel peut être une maille carrée.

Si ledit micro-système est destiné à recevoir des billes de diamètres différents, les éléments bloquants seront répartis de façon à obtenir une localisation des billes en fonction de leurs diamètres.

Selon un mode particulier de réalisation de l'invention, les éléments bloquants seront répartis de manière à constituer des puits destinés à recevoir des billes d'un premier diamètre déterminé et des espaces entre les puits destinés à recevoir des billes d'un second diamètre déterminé.

Quels que soient les modes de réalisation, les éléments bloquants du micro-système selon l'invention auront une section transversale de forme quelconque. Cependant, de manière avantageuse, leurs sections auront une forme choisie parmi les disques, les ellipses et les polygones.

Selon un mode particulier de réalisation, les éléments bloquants auront une section transversale de la forme d'un hexagone.

Avantageusement, les éléments bloquants auront une hauteur permettant l'empilement d'au moins deux billes.

Un autre objet de l'invention consiste en un micro-réacteur.

Selon un premier mode de réalisation, ledit micro-réacteur peut comprendre un micro-système rempli de billes d'un même diamètre et fonctionnalisées de manière identique, enchâssées entre les éléments bloquants.

Selon un autre mode de réalisation, ledit micro-réacteur comprendra un micro-système rempli de billes de même diamètre mais fonctionnalisées différemment, lesdites billes étant enchâssées entre les éléments bloquants, le rapport entre les quantités de billes portant des fonctions différentes étant choisi en fonction de l'effet désiré.

Selon un autre mode de réalisation, ledit micro-réacteur comprendra un micro-système rempli de billes de diamètres différents, chaque diamètre correspondant à une fonctionnalisation différente, lesdites billes étant enchâssées entre les éléments bloquants ; dans ce dernier mode, les billes d'un même diamètre constituent des zones fonctionnalisées localisées. Par « billes fonctionnalisées », il faut entendre « billes portant une fonction ou plusieurs fonctions différentes ».

Le but de l'invention est également de fournir un procédé de fabrication d'un micro-système selon l'invention, ledit procédé comportant les étapes suivantes :

- formation, par micro-usinage d'un substrat, du réservoir présentant la cavité munie des éléments bloquants,
- fourniture d'un capot destiné à fermer hermétiquement la cavité du réservoir,
- formation des moyens d'entrée et des moyens de sortie de fluide par micro-usinage du réservoir et/ou du capot.

Selon un mode de réalisation, ledit micro-usinage sera réalisé par procédé de gravure sèche ou humide d'un matériau.

Selon un autre mode de réalisation, ledit micro-usinage sera réalisé par procédé de moulage d'une empreinte.

Selon un autre mode de réalisation, ledit micro-usinage sera réalisé par procédé de photolithographie.

Un autre objet de l'invention concerne des procédés d'obtention de divers micro-réacteurs.

Tout d'abord, un procédé d'obtention d'un micro-réacteur comprenant un micro-système rempli de billes d'un même diamètre et de même fonction, ledit procédé comportant une étape de remplissage par sédimentation de billes fonctionnalisées en suspension dans un liquide.

En d'autres termes, le procédé comprend les étapes suivantes :

- placement du réservoir du micro-système au fond d'un récipient,
- introduction dans le récipient d'une solution contenant les billes fonctionnalisées en suspension et remplissage des interstices de la cavité par sédimentation des billes,
- fermeture du réservoir par le capot.

L'invention concerne également un procédé d'obtention d'un micro-réacteur multi-fonctionnel par remplissage d'un micro-système avec des billes fonctionnalisées d'un même diamètre mais de fonctions différentes, ledit procédé comprenant :

- pour les billes fonctionnalisées selon une première fonction, les étapes suivantes :

    a) placement d'un cache sur le réservoir du micro-système laissant accessible la partie dans laquelle on veut placer les billes d'une première fonction,
    b) remplissage par sédimentation,
    c) retrait du cache,

- pour les billes fonctionnalisées selon une autre fonction, la répétition, autant de fois qu'il y a de fonctions restantes, des étapes a) à c) avec des billes de ladite autre fonction,
- fermeture du réservoir par le capot.

Enfin, le procédé d'obtention d'un micro-réacteur multi-fonctionnel par remplissage du micro-système avec des billes dont la fonction est reliée au diamètre desdites billes, ledit procédé comprenant au moins deux étapes de remplissage, l'ordre des étapes de remplissage correspondant à l'ordre décroissant du diamètre des billes.

En d'autres termes, ledit procédé comprend :

- pour les billes de plus gros diamètre, les étapes suivantes :

    a) placement du réservoir du micro-système au fond d'un récipient,
    b) introduction dans le récipient d'une solution contenant les billes et remplissage des interstices de la cavité par sédimentation des billes,

- pour les billes de plus petit diamètre, la répétition, autant de fois que nécessaire et par ordre décroissant de diamètre, des étapes a) et b),
- fermeture du réservoir par le capot.

Un micro-système à remplissage de billes fonctionnalisées conçu conformément à l'invention présente un certain nombre d'avantages.

Le dispositif permet de développer une surface de réaction très importante avec en plus une géométrie en trois dimensions.

De plus, le micro-système selon l'invention et son mode de remplissage, puisqu'il permet d'empiler et de localiser précisément les billes à l'intérieur du micro-système, permet également d'obtenir une multi-fonctionnalisation en volume par dépôts de micro-billes ayant des fonctions différentes. En effet, comme on l'a vu précédemment, on peut intégrer des micro-billes de natures différentes sur un même dispositif.

Par ailleurs, en garantissant un espace inter-billes contrôlé dans tout le micro-système, il n'y a plus de risque d'agrégat des billes conduisant à un bouchage du micro-système.

Ce dispositif permet également une étape de remplissage aisé.

De même, l'expulsion des micro-billes est facilitée. En effet, si le scellement du réacteur n'est pas définitif, le capot peut être enlevé. Dans ce cas, le passage du micro-réacteur dans une solution de rinçage couplé à une agitation par ultrasons permet d'expulser les micro-billes de leur logement. Il suffit ensuite de recommencer l'opération de remplissage pour pouvoir disposer à nouveau d'un dispositif. Ce procédé permet alors, soit de réactiver la fonction apportée par les billes qui peut se dégrader dans le temps, soit de changer la fonction réalisée par le micro-réacteur tout en gardant sa géométrie.

Par ailleurs, l'invention concerne également un procédé pour réaliser une réaction chimique, électrochimique, biochimique ou biologique dans lequel on fait circuler un courant de fluide dans un micro-réacteur selon l'invention, afin qu'au moins un constituant dudit courant de fluide réagisse avec les billes préfonctionnalisées susceptibles de produire une réaction chimique, électrochimique, biologique ou biochimique, et on recueille à la(les) sortie(s) du micro-réacteur un courant de fluide comprenant le(les) produit(s) de ladite réaction.

Selon un mode préféré de l'invention, ladite réaction est une réaction de type enzyme substrat et lesdites billes préfonctionnalisées susceptibles de produire une réaction biologique ou biochimique sont des enzymes, ledit constituant du courant de fluide est un substrat de l'enzyme, et les produits de la réaction sont les produits issus de la réaction dudit enzyme avec ledit substrat.

Selon un autre mode de l'invention, ladite réaction est une réaction de digestion enzymatique par une protéase, lesdites billes préfonctionnalisées susceptibles de produire une réaction biologique ou biochimique sont des protéases et lesdits constituants du courant de fluide sont des peptides ou des protéines et les produits de la réaction sont des segments peptidiques.

Avantageusement, ladite enzyme est la trypsine.

Ces modes de l'invention illustrent des applications dans le domaine biologique, mais bien d'autres applications peuvent être concernées dans les domaines de la chimie (par exemple de la chimie fine), de l'électrochimie et de la biochimie, en particulier dans tous les cas où les réactions nécessitent l'utilisation de réactifs rares et/ou onéreux pour n'avoir à mettre en jeu que de petites quantités de réactifs.

## Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :

- la figure 1 est une vue de dessus en perspective du micro-système,
- la figure 2 est une vue de dessus partielle du micro-système de la figure 1 rempli avec des billes et illustrant un des arrangements possibles des éléments bloquants et desdites billes,
- la figure 3 est une coupe de la figure 2 selon l'axe III/III,
- les figures 4, 5 et 6 sont des vues de dessus partielles du micro-système rempli de billes illustrant divers arrangements possibles des éléments bloquants et desdites billes,
- les figures 7A à 7F illustrent la fabrication par procédé de gravure sèche d'un micro-système selon l'invention.

## Description détaillée de modes de réalisation de l'invention

En se reportant à la figure 1, on peut voir le micro-système 1 selon l'invention destiné à recevoir des billes et qui comporte :

- un réservoir 3 présentant une cavité 4, ladite cavité 4 étant munie d'éléments bloquants 5 permettant d'ordonner et d'empiler les billes dans les interstices entre les éléments bloquants 5,
- un capot 7 fixé hermétiquement au réservoir 3,
- et un moyen d'entrée 8 et un moyen de sortie 9 permettant la circulation d'un fluide dans la cavité.

Selon la manière dont les éléments bloquants vont être distribués dans le réservoir, on n'aura pas la même densité de billes. C'est l'arrangement spatial et la hauteur des éléments bloquants qui vont définir respectivement la surface d'accessibilité et le volume à occuper par les billes.

Dans un mode de réalisation particulier où l'on veut insérer des billes d'un même diamètre, les éléments bloquants sont régulièrement disposés selon un réseau bidimensionnel particulier. Ainsi, à partir d'un arrangement de colonnes hexagonales disposées selon une maille hexagonale, on obtient un empilement des micro-billes 2 dans les interstices 6 entre les colonnes 5 tel que celui représenté dans la figure 2. On voit sur cette figure que les billes 2 sont localisées dans les parties des interstices 6 délimitées par les arêtes de trois colonnes adjacentes.

La vue en coupe de la figure 2 selon l'axe III/III (figure 3) permet de bien visualiser l'empilement des micro-billes 2 entre les colonnes 5.

Sur la figure 4, les colonnes 15 sont aussi disposées selon une maille hexagonale mais l'écartement entre celles ci a été volontairement choisi plus petit : seules des billes 12 de plus petits diamètres que les billes des figures 2 ou 3 peuvent être insérées dans les interstices 16.

A partir du même raisonnement, plusieurs types de matriçage peuvent être envisagés dès lors que l'on peut modifier l'arrangement spatial des colonnes. Ainsi, en disposant les colonnes 25, de section hexagonale, selon un réseau carré, on obtient l'arrangement décrit sur la figure 5 : des billes 22 d'un diamètre déterminé sont insérées dans les parties des interstices 26 délimitées par les faces de quatre colonnes adjacentes.

On peut également insérer des billes de diamètres différents à l'intérieur du micro-système. Dans la figure 6, les éléments bloquants 35 sont répartis de manière à constituer des puits destinés à recevoir les billes de gros diamètre 32a et les billes de petit diamètre 32b vont se loger dans les espaces 36 entre les puits. On voit qu'ici ce ne sont pas les éléments bloquants en eux même mais bien un ensemble d'éléments bloquants (les puits) qui sont répartis selon un réseau bidimensionnel particulier, qui est ici hexagonal. Ces puits peuvent aussi être constitués par des colonnes creuses dont l'enveloppe remplace les éléments bloquants 35.

Dans la réalisation du micro-réacteur, on peut distinguer deux étapes :

- la première étape consiste à réaliser le micro-système en lui-même, c'est à dire disposer l'ensemble des éléments servant à bloquer les billes à l'intérieur du réservoir,
- la deuxième étape se rapporte à l'implantation desdites billes entre lesdits éléments bloquants.

La première étape, c'est à dire l'étape de micro-usinage du micro-système, peut être obtenue de plusieurs façons distinctes : soit par gravure sèche ou humide d'un matériau, soit par moulage d'une empreinte, soit par photolithographie.

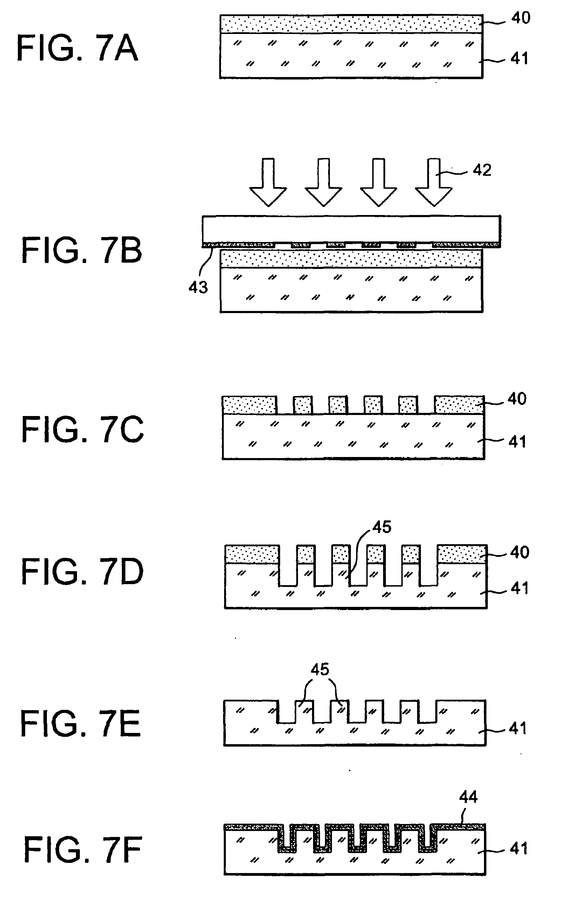

Comme exemple non limitatif et illustratif d'une méthode de micro-usinage, on choisit d'expliciter la fabrication d'un micro-réacteur en silicium par gravure sèche, en référence aux figures 7A à 7F jointes. Mais d'autres matériaux sont utilisables : par exemple, le verre, la silice, les résines, les polymères, voire même les métaux. Le matériau sera choisi selon l'application.

Tout d'abord, on dépose sur un substrat 41 en silicium de quatre pouces (soit 10,16 cm), de type <100> et d'épaisseur 525 $\mu$m, une couche de résine photosensible positive 40 par « spin-coating » (dépôt à la tournette) et en utilisant comme promoteur d'adhérence le produit HMDS que l'on fait chauffer à 150°C pendant 60 secondes (voir la figure 7A). On étale la résine à une vitesse de 4000 tr/min pendant 30 secondes et pour une accélération de 1500 tr/min/s.

Puis on fait sécher le substrat recouvert de résine pendant 60 secondes à 115°C.

On procède ensuite à une lithographie à l'aide d'un faisceau insolateur UV 42 qui passe au travers d'un masque 43 pourvu de n motifs définissant la géométrie du réservoir du micro-système (voir la figure 7B).

Selon la figure 7C, on procède ensuite à un développement sur track (SHIPLEY® MF 319) pendant 60 secondes, puis on recuit le substrat muni de sa résine à 115°C pendant 2 minutes. Après, le motif est soumis à une désoxydation des fonds de motif à l'aide d'un appareil RIE Nextral NE110 dans une atmosphère de $CHF_3/O_2$ à un rapport de débit de 50/10 $cm^3$ normaux/minutes (50/10 sccm), sous une pression de 13,332 Pa (100 mT), avec une puissance de 30 W, pendant 1 minute.

Ensuite, selon la figure 7D, on grave les zones non protégées par la résine à l'aide d'un appareil de gravure profonde du type DRIE ICP. On obtient ainsi les éléments bloquants 45. Pour les cycles de gravure, on utilise du $SF_6$ et les paramètres suivants : 129 $cm^3$ normaux/minutes (129 sccm), 5,133 Pa (38,5 mT) et 600 W. Pour les cycles de passivation, on utilise du $C_4F_8$ et les paramètres suivants : 85 $cm^3$ normaux/minutes (85 sccm), 3,733 Pa (28 mT) et 600 W. On précise que le rapport des temps de gravure par rapport aux temps de passivation est ajusté pour obtenir

des flancs droits.

L'étape suivante consiste à décaper le masque de résine à l'aide d'acide nitrique $HNO_3$ fumant sous ultrasons pendant 5 minutes.

Les flancs de la gravure sont alors nettoyés par oxydation en four à tube sous oxygène pendant 50 minutes à 1 000°C et puis par désoxydation chimique à l'aide de HF pendant quelques secondes (figure 7E).

On réalise ensuite une oxydation 44 épaisse des motifs sur une épaisseur de 3 μm dans un four à tube sous vapeur d'eau à 1 000°C pendant 18 heures et 50 minutes (figure 7F).

En utilisant une de ces méthodes de micro-usinage, il faut également creuser les moyens d'entrée et les moyens de sortie d'un fluide dans le micro-système. Ces moyens d'entrée et de sortie de fluide peuvent être faits dans le réservoir et/ou dans le capot.

Après cette succession d'étapes, nous obtenons un dispositif semblable à celui montré sur la figure 1, où les moyens d'entrée et de sortie de fluide ont été creusés dans le réservoir.

Selon une variante non illustrée, les moyens d'entrée et de sortie peuvent être dans le capot, ou indifféremment dans le capot et dans le réservoir.

Il faut à présent commencer la deuxième étape : l'étape d'implantation des billes au sein du micro-système.

La voie d'accès la plus aisée pour le remplissage avec les micro-billes est par-dessus les éléments bloquants. Ceci peut être aisément réalisé en plaçant le micro-système à remplir au fond d'un récipient. Une certaine quantité de micro-billes d'un diamètre déterminé est mise en suspension dans un liquide dont la viscosité et la densité sont connues. L'homogénéité de la solution peut être augmentée si l'on utilise des ultrasons afin d'éviter tout agrégat de micro-billes ou bien si l'on ajoute du surfactant à la solution. Cette suspension est ensuite versée dans le récipient contenant le dispositif à remplir. Les micro-billes en suspension sédimentent et viennent remplir les espaces libres ou interstices entre les éléments bloquants.

Le temps minimal au bout duquel le dispositif peut être retiré de la suspension est relié à la loi de Stokes déterminant le temps de sédimentation d'une sphère dans un milieu liquide selon l'équation :

$$t_{sédimentation} = \frac{9n}{2 \times g \times a^2 \times (\rho_1 - \rho_2)} \times d$$

Avec,

- n : coefficient de viscosité du milieu liquide (g/cm.s),
- d : hauteur maximale de liquide (cm),
- g :constante ($cm/s^2$),
- a: rayon des micro-sphères (cm),
- $\rho_1$: masse volumique des micro-sphères ($g/cm^3$),
- $\rho_2$: masse volumique du milieu liquide ($g/cm^3$).

Par exemple, le temps de sédimentation d'une bille en polystyrène de 5 micromètres de diamètre et pour une hauteur de 1 cm est de l'ordre de 4 heures.

Enfin, il faut empêcher les billes de sortir du micro-système. Pour cela, on fixe hermétiquement le capot 7 sur le réservoir 3 (voir figure 1).

Il y a plusieurs manières de fixer ce capot. Par exemple, le réservoir du micro-réacteur peut être capoté par une plaque en PDMS (polydiméthylsiloxane), comportant ou non des moyens d'entrée et/ou de sortie, après traitement dudit capot et du réservoir par un plasma d'oxygène, tel que décrit dans la littérature. Dans ce cas, le PDMS est connu pour avoir des propriétés d'adhésion spontanée sur la plupart les supports solides. Dans le cas d'un micro-réacteur à capot amovible, la plaque de PDMS est simplement pressée sur le réservoir, cela suffit à obtenir une bonne étanchéité tout en préservant la possibilité de réouverture du micro-réacteur ultérieurement après utilisation par un simple retrait de la plaque de PDMS. Le PDMS est cité à titre d'exemple mais d'autres matériaux polymères sont possibles.

Le réservoir du micro-réacteur peut être aussi, par exemple, capoté par scellement moléculaire d'une plaque de silice ou d'une plaque de verre, comportant ou pas des moyens d'entrée et/ou de sortie, après nettoyage et préparation chimique des deux substrats hydroxylés (substrat $SiO_2$ sur silicium/capot verre ou silice). La présence de sites silanols (SiOH) en surface attire spontanément les molécules d'eau, et les deux pièces du micro-composant, à savoir le capot 7 et le réservoir 3, collent l'une à l'autre par l'intermédiaire de molécules d'eau. Par chauffage, une partie de l'eau contenue entre les deux surfaces est éliminée jusqu'à l'obtention d'environ trois couches de molécules d'eau qui rendent possible l'adhésion.

Ou bien le réservoir du micro-réacteur peut être, par exemple, capoté par scellement anodique d'une plaque de verre, comportant ou pas des moyens d'entrée et/ou de sortie.
Ou bien le réservoir du micro-réacteur peut être, par exemple, capoté par collage d'une plaque polymère choisie par l'utilisateur, comportant ou pas des moyens d'entrée et/ou de sortie, en utilisant, par exemple, un procédé de dépôt de colle par sérigraphie.
Ce type de collage est constitué de trois étapes principales : la sérigraphie, qui consiste à appliquer de la colle uniquement sur certaines zones du substrat, le collage qui consiste à mettre en contact le substrat enduit localement de colle et le capot, et, enfin, le chauffage qui induit la polymérisation de la colle. La polymérisation peut s'effectuer par voie photochimique si la colle est polymérisable sous UV.
Enfin, le réservoir du micro-réacteur peut être, par exemple, capoté par scellement direct silicium/silicium (SDB : Silicon Direct Bonding, en anglais) à une plaque de silicium, comportant ou pas des moyens d'entrée et/ou de sortie.
Selon l'invention, on peut également réaliser un micro-réacteur multi-fonctionnel en volume en déposant, dans le réservoir du micro-système, des micro-billes ayant des fonctions différentes. En effet, sur un même dispositif, on peut intégrer des micro-billes de natures différentes selon plusieurs méthodes.
La première méthode nécessite l'emploi de billes fonctionnalisées d'un même diamètre mais ayant des fonctions différentes et fait intervenir un masquage de la zone à ne pas remplir par sédimentation.
La deuxième façon d'obtenir des micro-billes présentant des fonctions différentes dans un même micro-système peut se faire en disposant les éléments bloquants dans le réservoir avec des écartements différents. La sélectivité des zones de la cavité ayant différentes fonctions est alors liée au diamètre des différentes micro-sphères comportant ces fonctions. Le remplissage par sédimentation doit alors toujours débuter par les micro-sphères les plus grosses.
Un exemple du résultat obtenu est visible dans la figure 6, où l'on a utilisé deux diamètres de billes 32a et 32b et des éléments bloquants 35 répartis de manière à constituer des puits.

**<u>Quelques exemples d'application</u> :**

Le micro-réacteur selon l'invention peut être utilisé dans plusieurs applications différentes dans le domaine des réactions chimiques, électrochimiques, biochimiques ou biologiques.
Le micro-réacteur selon l'invention peut ainsi être utilisé dans le domaine de la biochimie, notamment, par exemple, dans une réaction de digestion enzymatique. Pour cela, on peut utiliser des micro-billes, poreuses ou non, fonctionnalisées avec de la trypsine, puis introduites dans le micro-système selon l'invention. On va alors faire circuler un courant de fluide dans ledit micro-réacteur de sorte qu'au moins un constituant dudit courant de fluide réagisse avec les billes préfonctionnalisées susceptibles de produire une réaction biologique ou biochimique, et on recueille à la(les) sortie(s) 9 du micro-réacteur un courant de fluide comprenant le(les) produit(s) de ladite réaction.
Le micro-réacteur selon l'invention peut également être utilisé en analyse.
Par exemple, le micro-système rempli de billes selon l'invention peut être utilisé pour les chromatographies de partage. On utilise pour cela des micro-billes, poreuses ou non, supportant des phases greffées polaires (-CN, -NH2) que l'on introduit dans le micro-système.
On peut également utiliser des micro-billes, poreuses ou non, supportant des phases greffées apolaires que l'on introduit dans le micro-système pour réaliser une chromatographie type échangeuse d'ions.
Le micro-système rempli de billes selon l'invention peut également être utilisé pour réaliser des chromatographies d'exclusion.
Dans ce but, on utilisera des billes poreuses dont les diamètres des pores seront adaptés au degré d'exclusion désiré.
Le micro-système rempli de billes selon l'invention peut aussi être utilisé pour réaliser des chromatographies d'affinité. On utilisera alors des micro-billes, poreuses ou non, supportant un effecteur présentant une affinité biologique (enzyme-substrat, ligand-récepteur, antigène-anticorps) pour un soluté d'un échantillon à analyser.
Pour effectuer une chromatographie d'affinité enzyme-substrat, on pourra notamment prendre comme effecteurs des substrats ou analogues, des inhibiteurs réversibles, des effecteurs allostériques ou des coenzymes.
Ou encore, pour effectuer une chromatographie d'affinité ligand-récepteur, on utilisera des haptènes, des antigènes ou des anticorps.
Pour effectuer une chromatographie d'affinité antigène-anticorps, on prendra par exemple des hormones, des peptides ou des analogues peptidiques.
Le micro-réacteur selon l'invention peut aussi être utilisé dans des réactions chimiques.
Le micro-réacteur permet en effet de créer un système générant un parfait support catalytique en permettant l'ordonnancement de micro-billes poreuses imprégnées de catalyseur. Cet ordonnancement géométrique des micro-billes permet, d'une part, d'augmenter très sensiblement le rapport surface sur volume et, d'autre part, d'obtenir une distribution homogène du flux à l'intérieur du réacteur.
De plus, les billes poreuses utilisées peuvent être un mélange de billes portant différents types de catalyseurs

(par exemple : Pd, Pt, Rh...).

La surface interne du micro-réacteur peut elle-même être recouverte d'une couche catalytique, notamment par traitement chimique de surface, par sputtering ou par co-évaporation.

Un nombre important de réactions catalytiques en phase liquide peuvent être transposées dans un micro-réacteur, comme par exemple la réaction de couplage de Suzuki :

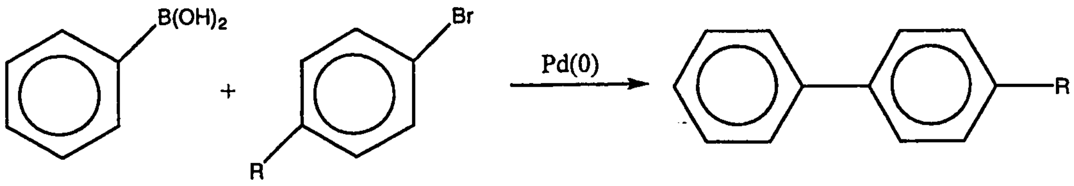


On peut citer également le couplage entre le 4-bromobenzonitrile et l'acide phénylboronique qui peut être réalisé sous flux électro-osmotique :

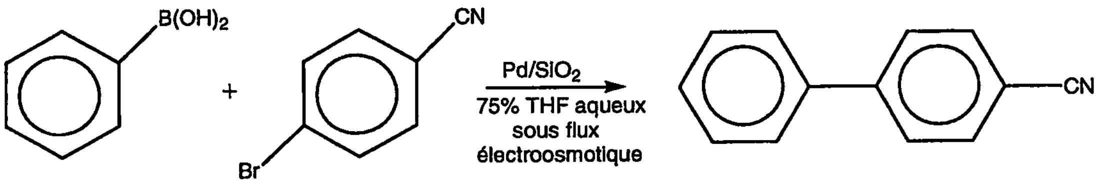


L'efficacité des micro-réacteur concernant l'augmentation des rendements réactionnels à l'échelle microscopique a été démontrée dans le document [5].

## REFERENCES

**[1]** R.D. OLESCHUK, L.L. SHULTZ-LOCKYEAR, Y. NING, D.J. HARRISON, Analytical Chemistry 72, 585-590 (2000).

**[2]** C. WANG, R. OLESCHUK, F. OUCHEN, J. LI, P. THIBAULT, D.J. HARRISON, Rapid Communications In Mass Spectrometry 14, 1377-1383 (2000).

**[3]** H. ANDERSSON, W. van der WIJNGAART, P. ENOKSSON, G. STEMME, Sensors and Actuators B 67, 203-208 (2000).

**[4]** H. ANDERSSON, C. JONSSON, C. MOBERG, G. STEMME, Micro Total Analysis Systems, J.M. RAMSEY and Van den BERG (eds.), (Kluwer academic Publishers, 2001).

**[5]** G.M. GREENWAY, S.J. HASWELL, D.O. MORGAN, V. SKELTON and P. STYRING, Sensors & Actuators B 63, 153 (2000).


## Revendications

1. Micro-système destiné à recevoir des billes et à obtenir une localisation précise desdites billes à des endroits déterminés dans le micro-système, **caractérisé en ce qu'**il comporte :

   - un réservoir (3) présentant une cavité (4) munie d'éléments bloquants (5,15,25,35), lesdits éléments bloquants permettant de bloquer les billes (2, 12, 22, 32a, 32b) dans les interstices (6, 16, 26, 36) entre les éléments bloquants (5,15,25,35) de manière ordonnée et selon des empilements, les interstices (6,16,26,36) constituant

lesdits endroits déterminés,
- un capot (7) fixé hermétiquement au réservoir (3),
- et des moyens d'entrée (8) et des moyens de sortie (9) permettant la circulation d'un fluide dans la cavité (4),

**caractérisé en ce que** lesdits éléments bloquants (5,15,25,35) ont une forme de colonne et **en ce que** chaque endroit déterminé comprend un seul empilement de billes, les billes dans chaque empilement étant disposées l'une sur l'autre de sorte que chaque bille soit en contact au plus avec deux billes et les empilements étant localisés de manière à ce que les billes d'un empilement ne soient pas en contact avec les billes d'un autre empilement.

**2.** Micro-système selon la revendication 1 **caractérisé en ce que** les éléments bloquants (5,15,25,35) sont solidaires du fond de la cavité ou du capot.

**3.** Micro-système selon la revendication 1 ou 2 **caractérisé en ce que**, les billes (2,12,22) ayant toutes le même diamètre, les éléments bloquants (5,15,25) sont régulièrement disposés selon un réseau bidimensionnel.

**4.** Micro-système selon la revendication 1 ou 2 **caractérisé en ce que**, le micro-système (1) devant recevoir des billes (32a,32b) de diamètres différents, les éléments bloquants (35) sont répartis de façon à obtenir une localisation des billes (32a,32b) en fonction de leurs diamètres.

**5.** Micro-système selon la revendication 4 **caractérisé en ce que** les éléments bloquants (35) sont répartis pour constituer des puits destinés à recevoir des billes (32a) d'un premier diamètre déterminé et des espaces entre les puits destinés à recevoir des billes (32b) d'un second diamètre déterminé.

**6.** Micro-système selon la revendication 3 **caractérisé en ce que** le réseau bidimensionnel est une maille hexagonale.

**7.** Micro-système selon la revendication 3 **caractérisé en ce que** le réseau bidimensionnel est une maille carrée.

**8.** Micro-système selon l'une quelconque des revendications précédentes **caractérisé en ce que** les éléments bloquants (5,15,25,35) ont une section transversale de forme choisie parmi les disques, ellipses, et polygones.

**9.** Micro-système selon la revendication 8 **caractérisé en ce que** les éléments bloquants (5,15,25, 35) ont une section transversale de la forme d'un hexagone.

**10.** Micro-système selon l'une quelconque des revendications précédentes **caractérisé en ce que** les éléments bloquants (5,15,25,35) ont une hauteur permettant l'empilement d'au moins deux billes.

**11.** Micro-réacteur comprenant un micro-système selon l'une quelconque des revendications 1, 2, 3, 6 à 10 et des billes (2,12,22), d'un même diamètre et de même fonction, enchâssées entre les éléments bloquants (5,15,25).

**12.** Micro-réacteur comprenant un micro-système selon l'une quelconque des revendications 1, 2, 3, 6 à 10 et des billes (2,12,22), de même diamètre mais fonctionnalisées différemment, enchâssées entre les éléments bloquants (5,15,25).

**13.** Micro-réacteur comprenant un micro-système selon l'une quelconque des revendications 1, 2, 4, 5, 8 à 10 et des billes (32a,32b), de même fonction mais de diamètres différents, enchâssées entre les éléments bloquants (5,15,25,35).

**14.** Micro-réacteur comprenant un micro-système selon l'une quelconque des revendications 1, 2, 4, 5, 8 à 10 et des billes (32a,32b), de diamètres et de fonctions différents, enchâssées entre les éléments bloquants (5,15,25,35).

**15.** Procédé de fabrication d'un micro-système selon l'une quelconque des revendications 1 à 10, ledit procédé comportant les étapes suivantes :

- formation, par micro-usinage d'un substrat (41), du réservoir présentant la cavité munie des éléments bloquants (45),
- fourniture d'un capot (7) destiné à fermer hermétiquement la cavité (4) du réservoir (3),
- formation des moyens d'entrée (8) et des moyens de sortie (9) de fluide par micro-usinage du réservoir (3) et/ou du capot (7).

**16.** Procédé selon la revendication 15, dans lequel le micro-usinage est réalisé par procédé de gravure sèche ou humide d'un matériau.

**17.** Procédé selon la revendication 15, dans lequel le micro-usinage est réalisé par procédé de moulage d'une empreinte.

**18.** Procédé selon la revendication 15, dans lequel le micro-usinage est réalisé par procédé de photolithographie.

**19.** Procédé d'obtention du micro-réacteur selon la revendication 11, ledit procédé comportant une étape de remplissage par sédimentation de billes fonctionnalisées en suspension dans un liquide.

**20.** Procédé d'obtention d'un micro-réacteur multi-fonctionnel par remplissage du micro-système, selon la revendication 3, avec des billes fonctionnalisées d'un même diamètre mais de fonctions différentes, **caractérisé en ce que** ledit procédé comprend :

- pour les billes fonctionnalisées selon une première fonction, les étapes suivantes :

  a) placement d'un cache sur le réservoir (3) du micro-système laissant accessible la partie dans laquelle on veut placer les billes d'une première fonction,
  b) remplissage par sédimentation,
  c) retrait du cache (7),

- pour les billes fonctionnalisées selon une autre fonction, la répétition, autant de fois qu'il y a de fonctions restantes, des étapes a) à c) avec des billes de ladite autre fonction,
- fermeture du réservoir (3) par le capot (7).

**21.** Procédé d'obtention d'un micro-réacteur multi-fonctionnel par remplissage du micro-système selon l'une des revendications 4 ou 5 avec des billes dont la fonction est reliée au diamètre desdites billes, **caractérisé en ce que** ledit procédé comprend au moins deux étapes de remplissage, l'ordre des étapes de remplissage correspondant à l'ordre décroissant du diamètre des billes.

**22.** Procédé pour réaliser une réaction biochimique ou biologique dans lequel on fait circuler un courant de fluide dans un micro-réacteur selon l'une quelconque des revendications 11 à 13, afin qu'au moins un constituant dudit courant de fluide réagisse avec les billes (2,12,22,32a,32b) préfonctionnalisées susceptibles de produire une réaction chimique, électrochimique, biologique ou biochimique, et on recueille à la(les) sortie(s) (9) du micro-réacteur un courant de fluide comprenant le(les) produit(s) de ladite réaction.

**23.** Procédé selon la revendication 22, dans lequel ladite réaction est une réaction de type enzyme substrat, lesdites billes (2,12,22,32a,32b) préfonctionnalisées susceptibles de produire une réaction biologique ou biochimique sont des enzymes, ledit constituant du courant de fluide est un substrat de l'enzyme, et les produits de la réaction sont les produits issus de la réaction dudit enzyme avec ledit substrat.

**24.** Procédé selon la revendication 22, dans lequel ladite réaction est une réaction de digestion enzymatique par une protéase, lesdites billes (2,12,22,32a,32b) préfonctionnalisées susceptibles de produire une réaction biologique ou biochimique sont des protéases et lesdits constituants du courant de fluide sont des peptides ou des protéines et les produits de la réaction sont des segments peptidiques.

**25.** Procédé selon la revendication 24, dans lequel l'enzyme est la trypsine.

## Claims

**1.** Micro-system intended to receive beads and to obtain a precise positioning of said beads at preset locations in the micro-system,
**characterized in that** it comprises:

- a tank (3) that has a cavity (4), said cavity (4) being fitted with blocking elements (5, 15, 25, 35) that allow the beads (2, 12, 22, 32a, 32b) to be ordered and stacked in the interstices (6, 16, 26, 36) between the blocking elements (5, 15, 25, 35), the interstices (6, 16, 26, 36) constituting said preset locations,

- a cap (7) hermetically sealing the tank (3),
- and input means (8) and output means (9) allowing a fluid to flow in the cavity (4),

**characterized in that** said blocking elements (5, 15, 25, 35) are in the form of a column and **in that** each given location comprises a single pile of beads, the beads in each pile being superimposed in such a way that each bead is at the most in contact with two beads and the piles are positioned in such a way that the beads of one pile are not in contact with the beads of another pile.

2. Micro-system according to claim 1, **characterized in that** the blocking elements (5, 15, 25, 35) consist of columns that are integral with the bottom of the cavity or the cap.

3. Micro-system according to claim 1, **characterized in that**, the beads (2, 12, 22) all having the same diameter, the blocking elements (5, 15, 25) are evenly arranged in a two-dimensional network.

4. Micro-system according to claim 1 or 2, **characterized in that**, the micro-system (1) having to receive beads (32a, 32b) of different diameters, the blocking elements (35) are distributed so as to obtain a positioning of the beads (32a, 32b) as a function of their diameters.

5. Micro-system according to claim 4, **characterised in that** the blocking elements (35) are distributed so as to constitute wells intended to receive beads (32a) of a first preset diameter and spaces between the wells intended to receive beads (32b) of a second preset diameter.

6. Micro-system according to claim 3, **characterised in that** the two-dimensional network is a hexagonal mesh.

7. Micro-system according to claim 3, **characterised in that** the two-dimensional network is a square mesh.

8. Micro-system according to any one of the previous claims **characterised in that** the blocking elements (5, 15, 25, 35) have a transverse cross-section of a shape selected from among discs, ellipses and polygons.

9. Micro-system according to claim 8, **characterised in that** the blocking elements (5, 15, 25, 35) have a transverse cross-section in the shape of a hexagon.

10. Micro-system according to any one of the previous claims **characterised in that** the blocking elements (5, 15, 25, 35) are of a height that allows at least two beads to be stacked.

11. Micro-reactor including a micro-system according to any one of claims 1, 2, 3, 6 to 10 and beads (2, 12, 22) of one and the same diameter and with the same function, fitted between the blocking elements (5, 15, 25).

12. Micro-reactor including a micro-system according to any one of claims 1, 2, 3, 6 to 10 and beads (2, 12, 22), of the same diameter but functionalised differently, fitted between the blocking elements (5, 15, 25).

13. Micro-reactor including a micro-system according to any one of claims 1, 2, 4, 5, 8 to 10 and beads (32a, 32b), with the same function but of different diameters, fitted between the blocking elements (5, 15, 25, 35).

14. Micro-reactor including a micro-system according to any one of claims 1, 2, 4, 5, 8 to 10 and beads (32a, 32b), of different diameters and functions, fitted between the blocking elements (5, 15, 25, 35).

15. Process for making a micro-system according to any one of claims 1 to 10, said process comprising the following stages:

- forming, by micro-machining a substrate (41), the tank that has the cavity fitted with the blocking elements (45),
- supplying a cap (7) intended to seal the cavity (4) of the tank (3) hermetically,
- forming the fluid import means (8) and output means (9) by micro-machining the tank (3) and/or cap (7).

16. Process according to claim 15, wherein the micro-machining is carried out by a process of dry or wet etching a material.

17. Process according to claim 15, wherein the micro-machining is carried out by impression moulding process.

**18.** Process according to claim 15, wherein the micro-machining is carried out by photolithography process.

**19.** Process for obtaining the micro-reactor according to claim 11, said process comprising a stage of sedimentation filling with functionalised beads in suspension in a liquid.

**20.** Process for obtaining a multi-functional micro-reactor by filling the micro-system, according to claim 3, with functionalised beads of one and the same diameter but with different functions, **characterised in that** said process includes:

- for beads functionalised according to a first function, the following stages:

  a) placing a cover on the micro-system tank (3) leaving accessible the part in which it is wished to place the beads of a first function,
  b) filling by sedimentation,
  c) withdrawing the cover (7),

- for beads functionalised according to another function, the repetition, as many times as there are functions remaining, of stages a) to c) with beads of said other function,
- sealing the tank (3) with the cap (7).

**21.** Process for obtaining a multi-functional micro-reactor by filling the micro-system, according to one of claims 4 or 5, with beads the function of which is related to the diameter of said beads, **characterised in that** said process includes at least two filling stages, the order of the filling stages corresponding to the decreasing order of the diameter of the beads.

**22.** Process for implementing a biochemical or biological reaction wherein a fluid stream is made to flow in a micro-reactor according to any one of claims 11 to 13, so that at least one constituent of said fluid stream reacts with the pre-functionalised beads (2, 12, 22, 32a, 32b) able to produce a chemical, electrochemical, biological or biochemical reaction, and at the micro-reactor output(s) a fluid stream is collected that includes the product (s) of said reaction.

**23.** Process according to claim 22, wherein said reaction is a reaction of the substrate enzyme type, said pre-functionalised beads (2, 12, 22, 32a, 32b) able to produce a biological or biochemical reaction are enzymes, said constituent of the fluid stream is a substrate of the enzyme and the products of the reaction are the products arising from the reaction of said enzyme with said substrate.

**24.** Process according to claim 22, wherein said reaction is an enzymatic digestion reaction by a protease, said pre-functionalised beads (2, 12, 22, 32a, 32b) able to produce a biological or biochemical reaction are proteases and said constituents of the fluid stream are peptides or proteins and the products of the reaction are peptidic segments.

**25.** Process according to claim 24, wherein the enzyme is trypsin.

## Patentansprüche

**1.** Mikrosystem für die Aufnahme von Kugeln und für die Erzielung einer genauen Lokalisierung der genannten Kugeln an vorgegebenen Stellen in dem Mikrosystem, **dadurch gekennzeichnet, dass** es umfasst:

- einen Behälter (Reservoir) (3), der eine Vertiefung (Hohlraum) (4) aufweist, in der (dem) blockierende Elemente (5, 15, 25, 35) angeordnet sind, wobei die genannten blockierenden Elemente die Blockierung der Kugeln (2, 12, 22, 32a, 32b) in den Zwischenräumen (6, 16, 26, 36) zwischen den blockierenden Elementen (5, 15, 25, 35) in geordneter Weise und in Form von Stapeln erlauben, wobei die Zwischenräume (6, 16, 26, 36) die genannten vorgegebenen Stellen darstellen,
- eine Abdeckung (7), die an dem Behälter (Reservoir) (3) hermetisch fixiert ist, und
- Einführungseinrichtungen (8) und Auslasseinrichtungen (9), welche die Zirkulation einer Flüssigkeit (eines Fluids) in dem Hohlraum (4) erlauben,

**dadurch gekennzeichnet, dass** dia genannten blockierenden Elemente (5, 15, 25, 35) die Form einer Kolonne haben und dass jede vorgegebene Stelle einen einzigen Stapel von Kugeln umfasst, wobei die Kugeln in jedem

Stapel aufeinanderliegend so angeordnet sind, dass jede Kugel im Kontakt mit höchstens zwei Kugeln steht und die Stapel so angeordnet sind, dass dia Kugeln eines Stapels nicht mit den Kugeln eines anderen Stapels in Kontakt stehen.

2. Mikrosystem nach Anspruch 1, **dadurch gekennzeichnet, dass** die blockierenden Elemente (5, 15, 25, 35) mit dem Boden des Hohlraums oder mit der Abdeckung eine Einheit bilden (fest verbunden sind).

3. Mikrosystem nach Anspruch 1 oder 2, **dadurch gekennzeichnet, dass** die Kugeln (2, 12, 22) alle den gleichen Durchmesser haben und die blockierenden Elemente (5, 15, 25) in Form eines Raster- bzw. Flächengitters regelmäßig angeordnet sind.

4. Mikrosystem nach Anspruch 1 oder 2, **dadurch gekennzeichnet, dass** das Mikrosystem (1) vor der Aufnahme der Kugeln (32a, 32b) mit unterschiedlichen Durchmessern die blockierenden Elemente (35) so verteilt sind, dass eine Lokalisierung der Kugeln (32a, 32b) als Funktion ihrer Durchmesser erzielt wird.

5. Mikrosystem nach Anspruch 4, **dadurch gekennzeichnet, dass** die blockierenden Elemente (35) so verteilt sind, dass sie einen Schacht für die Aufnahme von Kugeln (32a) mit einem ersten gegebenen Durchmesser und Zwischenräume zwischen den Schächten für die Aufnahme von Kugeln (32b) mit einem zweiten festgelegten Durchmesser bilden.

6. Mikrosystem nach Anspruch 3, **dadurch gekennzeichnet, dass** das Raster- bzw. Flächengitter ein hexagonales Gitter ist.

7. Mikrosystem nach Anspruch 3, **dadurch gekennzeichnet, dass** das Raster- bzw. Flächengitter ein quadratisches Gitter ist.

8. Mikrosystem nach einem der vorhergehenden Ansprüche, **dadurch gekennzeichnet, dass** dia blockierenden Elemente (5, 15, 25, 35) einen Querschnitt mit einer Form haben, die ausgewählt ist aus der Gruppe der Scheiben, Ellipsen und Polygone.

9. Mikrosystem nach Anspruch 8, **dadurch gekennzeichnet, dass** die blockierenden Elemente (5, 15, 25, 35) einen Querschnitt in Form eines Hexagons haben.

10. Mikrosystem nach einem der vorhergehenden Ansprüche, **dadurch gekennzeichnet**, die blockierenden Elemente (5, 15, 25, 35) eine Höhe haben, welche die Aufeinanderstapelung von mindestens zwei Kugeln erlaubt.

11. Mikroreaktor, der ein Mikrosystem nach einem der Ansprüche 1, 2, 3, 6 bis 10 und Kugeln (2, 12, 22) mit gleichem Durchmesser und gleicher Funktion umfasst, die zwischen die blockierenden Elemente (5, 15, 25) passen.

12. Mikroreaktor, der ein Mikrosystem nach einem der Ansprüche 1, 2, 3, 6 bis 10 und Kugeln (2, 12, 22) mit gleichem Durchmesser, jedoch mit unterschiedlichen Funktionen umfasst, die zwischen die blockierenden Elemente (5, 15, 25) passen.

13. Mikroreaktor, der ein Mikrosystem nach einem der Ansprüche 1, 2, 4, 5, 8 bis 10 und Kugeln (32a, 32b) mit gleicher Funktion, jedoch mit unterschiedlichen Durchmessern umfasst, die zwischen die blockierenden Elemente (5, 15, 25, 35) passen.

14. Mikroreaktor, der ein Mikrosystem nach einem der Ansprüche 1, 2, 4, 5, 8 bis 10 und Kugeln (32a, 32b) mit unterschiedlichen Durchmessern und unterschiedlichen Funktionen umfasst, die zwischen die blockierenden Elemente (5, 15, 25, 35) passen.

15. Verfahren zur Herstellung eines Mikrosystems nach einem der Ansprüche 1 bis 10, wobei das Verfahren die folgenden Stufen umfasst:

   - Bildung (Formung) des Behälters (Reservoirs), der den Hohlraum mit den darin befindlichen blockierenden Elementen (45) darstellt, durch Mikrobearbeitung eines Substrats (41),
   - Anbringen einer Abdeckung (7), die bestimmt ist für den hermetischen Verschluss des Hohlraums (4) des Behälters (3) und

- Bildung (Formung) von Eintrittseinrichtungen (8) und Austrittseinrichtungen (9) für eine Flüssigkeit (ein Fluid) durch Mikrobearbeitung des Behälters (3) und/oder der Abdeckung (7).

**16.** Verfahren nach Anspruch 15, bei dem die Mikrobearbeitung durchgeführt wird durch Anwendung eines Verfahrens zum trockenen oder nassen Gravieren (Ätzen) eines Materials.

**17.** Verfahren nach Anspruch 15, bei dem die Mikrobearbeitung durchgeführt wird durch Anwendung eines Prägeform-Verfahrens.

**18.** Verfahren nach Anspruch 15, bei dem die Mikrobearbeitung durchgeführt wird durch Anwendung eines photolithographischen Verfahrens.

**19.** Verfahren zur Herstellung des Mikroreaktors nach Anspruch 11, das umfasst das Einfüllen von funktionalisierten Kugeln, die in einer Flüssigkeit suspendiert sind, durch Sedimentation.

**20.** Verfahren zur Herstellung eines multifunktionellen Mikroreaktors durch Füllen des Mikrosystems nach Anspruch 3 mit funktionalisierten Kugeln mit dem gleichen Durchmesser, jedoch unterschiedlichen Funktionen, **dadurch gekennzeichnet, dass** das genannte Verfahren umfasst:

- für die funktionalisierten Kugeln gemäß einer ersten Funktion die folgenden Stufen:

a) das Anbringen einer Abdeckung auf dem Behälter (3) des Mikrosystems, die den Abschnitt zugänglich lässt, in dem man die Kugeln einer ersten Funktion anordnen will,
b) das Füllen durch Sedimentation und
c) die Entfernung der Abdeckung (7), und

- für funktionalisierte Kugeln gemäß einer anderen Funktion die Wiederholung der Stufen (a) bis (c) mit Kugeln mit der genannten anderen Funktion so oft es noch verbleibende Funktionen gibt, und
- das Verschließen des Behälters (3) mit der Abdeckung (7).

**21.** Verfahren zur Herstellung eines multifunktionellen Mikroreaktors durch Füllen des Mikrosystems nach einem der Ansprüche 4 oder 5 mit Kugeln, deren Funktion mit dem Durchmesser der genannten Kugeln in Verbindung steht, **dadurch gekennzeichnet, dass** das genannte Verfahren mindestens zwei Füllungsstufen umfasst, wobei die Reihenfolge der Füllungsstufen der Reihenfolge der Abnahme des Durchmessers der Kugeln entspricht.

**22.** Verfahren zur Durchführung einer biochemischen oder biologischen Reaktion, bei dem man einen Flüssigkeits- bzw. Fluidstrom in einem Mikroreaktor nach einem der Ansprüche 11 bis 13 zirkulieren lässt, sodass mindestens ein Bestandteil des genannten Flüssigkeits- bzw. Fluidstroms mit den vortunktionalisierten Kugeln (2, 12, 22, 32a, 32b) reagiert, die eine chemische, elektrochemische, biologische oder biochemische Reaktion eingehen können, und dass man an dem (den) Ausgang (Ausgängen) (9) des Mikroreaktors einen Flüssigkeits- bzw. Fluidstrom abtrennt, der das (die) Produkt(e) der genannten Reaktion umfasst.

**23.** Verfahren nach Anspruch 22, bei dem die genannte Reaktion eine Reaktion vom Enzym-Substrat-Typ ist, wobei die genannten vorfunktionalisierten Kugeln (2, 12, 22, 32a, 32b), die eine biologische oder biochemische Reaktion eingehen können, Enzyme darstellen, der genannte Bestandteil des Flüssigkeits- bzw. Fluidstroms ein Enzymsubstrat ist und die Reaktionsprodukte die Produkte sind, die bei der Reaktion des genannten Enzyms mit dem genannten Substrat entstehen.

**24.** Verfahren nach Anspruch 22, bei dem die genannte Reaktion eine enzymatische Digerierungsreaktion durch eine Protease ist, wobei die genannten vorfunktionalisierten Kugeln (2, 12, 22, 32a, 32b), die eine biologische oder biochemische Reaktion eingehen können, Proteasen sind und die genannten Bestandteile des Flüssigkeits- bzw. Fluidstroms Peptide oder Proteine sind und die Reaktionsprodukte Peptidsegmente sind.

**25.** Verfahren nach Anspruch 24, bei dem das Enzym das Trypsin ist.

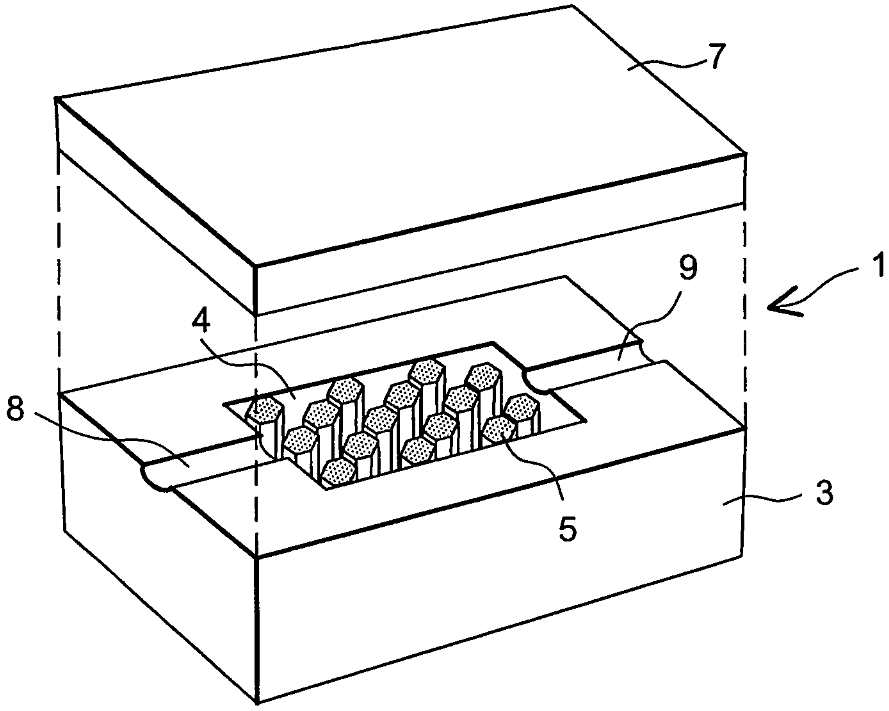


FIG. 1

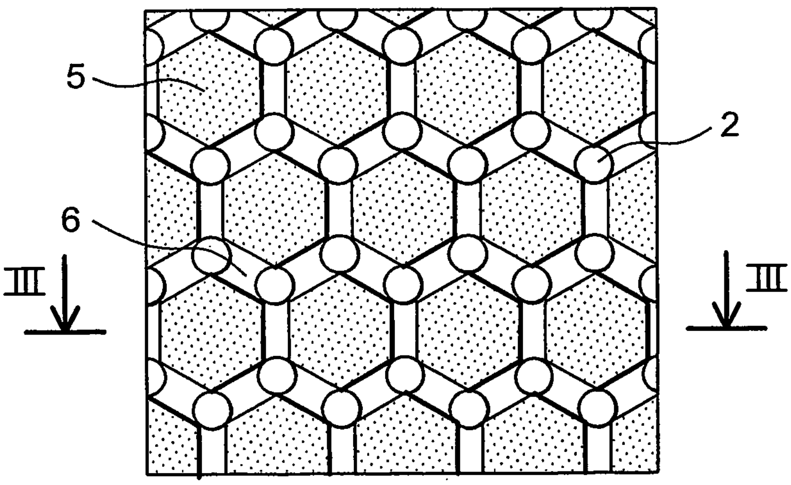


FIG. 2

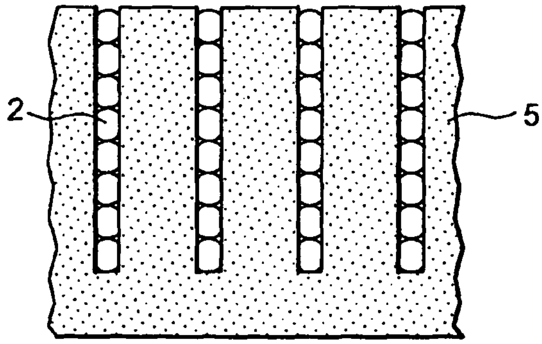


FIG. 3

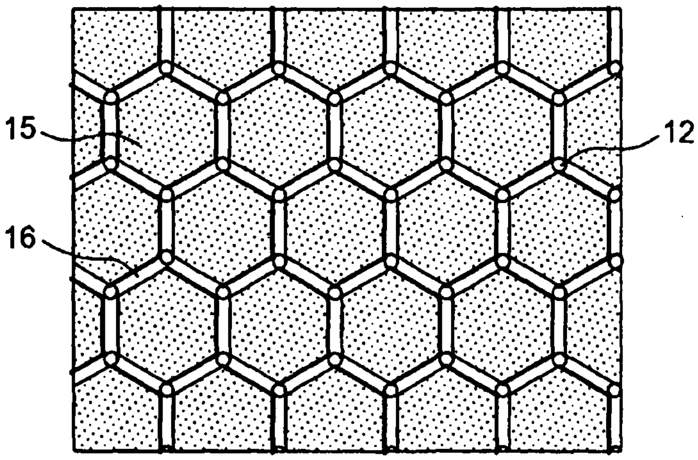


FIG. 4

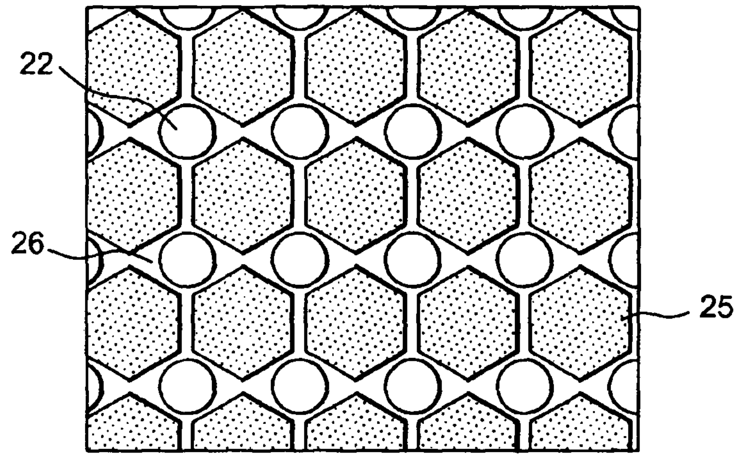


FIG. 5

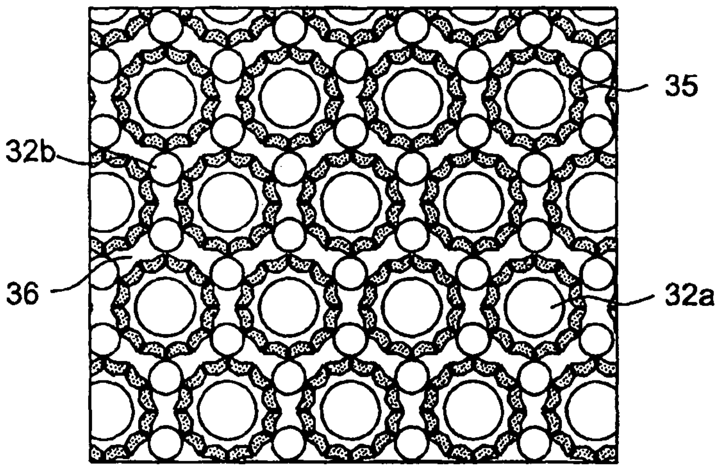


FIG. 6

FIG. 7A

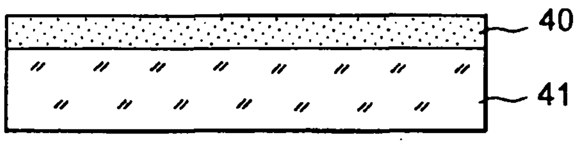


FIG. 7B

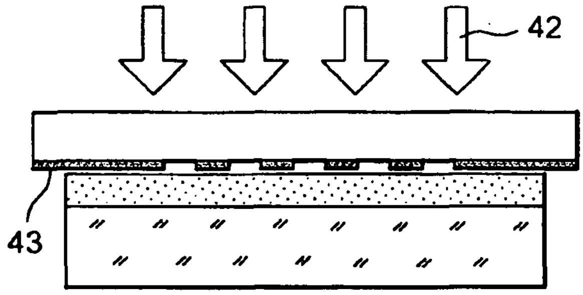


FIG. 7C

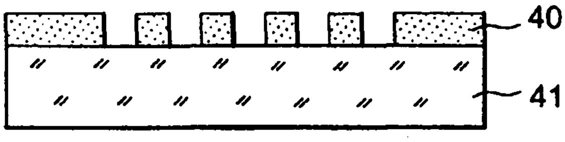


FIG. 7D

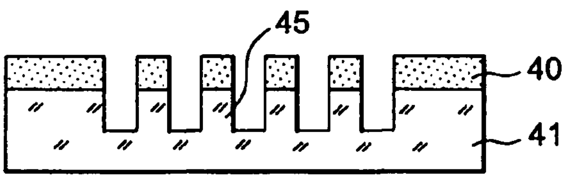


FIG. 7E

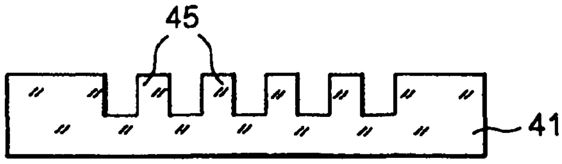


FIG. 7F